## Europäisches Patentamt
## European Patent Office
## Office européen des brevets

(19)

(11) Veröffentlichungsnummer: **0 089 624**
A2

(12) **EUROPÄISCHE PATENTANMELDUNG**

(21) Anmeldenummer: **83102631.5**

(51) Int. Cl.³: **H 03 K 13/20**

(22) Anmeldetag: **17.03.83**

(30) Priorität: **22.03.82 US 360735**

(43) Veröffentlichungstag der Anmeldung:
**28.09.83 - Patentblatt 83/39**

(84) Benannte Vertragsstaaten:
**DE FR GB NL**

(71) Anmelder: **International Standard Electric Corporation**
**320 Park Avenue**
**New York New York 10022(US)**

(72) Erfinder: **Chang, Hyokang**
**39 Martin Terr.**
**New Haven, CT(US)**

(72) Erfinder: **Shenoi, Kishan**
**50 Garden Dr.**
**Fairfield, CT(US)**

(72) Erfinder: **Agrawal, Bgahwati Prasad**
**81 Blueberry Lane**
**Shelton, CT(US)**

(74) Vertreter: **Graf, Georg H., Dipl.-Ing. et al,**
**c/o Standard Elektrik Lorenz AG Patent- und**
**Lizenzwesen Postfach 300 929 Kurze Strasse 8**
**D-7000 Stuttgart 30(DE)**

(54) Demodulator zur Umsetzung eines frequenzmodulierten Eingangssignals in ein digitales Ausgangssignal.

(57) Der erfindungsgemäße FM-Demodulator hat einen ersten Teil (4, 6, 5), der vom frequenzmodulierten Eingangssignal ein pulsdauermoduliertes Signal ableitet, bei dem die Dauer der Impulse proportional der momentanen Frequenzabweichung des FM-Eingangssignals von seiner Mittenfrequenz ($f_c$) ist. In einem nachgeschalteten zweiten Teil, der einen Delta-Sigma-Modulator (7) und einen Dezimator (8) enthält, wird das pulsdauermodulierte Signal in ein dem analogen FM-Eingangssignal des Demodulators entsprechendes digitales Ausgangssignal umgesetzt, wobei der Dezimator zuswätzlich die Funktion einer Deemphase-Schaltung zur Beseitigung der aus Übertragungsgründen vorhandenen Preemphase-Verzerrung des FM-Signals erfüllt.

Fig. 1

EP 0 089 624 A2

- 1 -                                    0089624


H.Chang-K.Shenoi-B.P.Agrawal 2-6-8

Demodulator zur Umsetzung eines frequenzmodulierten
Eingangssignals in ein digitales
Ausgangssignal

Die Erfindung betrifft einen Demodulator nach dem Oberbegriff des Patentanspruchs 1.

Verwendbar ist die Erfindung auf dem Gebiet der Nachrichtenübertragung allgemein, z. B. für Fernsehübertragung,
für Übertragungsstrecken mit Nachrichtensatelliten und
bei jedem Empfänger für frequenzmodulierte Eingangssignale, bei dem eine digitale Weiterverarbeitung des empfangenen Signals erfolgen soll.

Zur Umsetzung eines frequenzmodulierten Eingangssignals
in ein digitales Ausgangssignal sind Demodulatoren bekannt, die wie folgt arbeiten:

Ein analoges frequenzmoduliertes Eingangssignal, das im
folgenden als FM-Signal bezeichnet wird, wird nach Umsetzung in den Zwischenfrequenz-Stufen eines FM-Empfängers
in einem analogen FM-Demodulator demoduliert, und das
Ausgangssignal durchläuft ein Deemphase-Entzerrernetzwerk,
das die vorhandene Preemphase-Verzerrung beseitigt, die

H.Chang 2-6-8

bei der Übertragung des FM-Signals zur Vergrößerung des Geräuschabstands angewendet wird. Schließlich wird das demodulierte und entzerrte Analogsignal in einem Analog-Digital-Wandler in das gewünschte digitale Ausgangssignal umgesetzt. Ein solcher Demodulatoraufbau erfordert viele analoge Bauteile, weil die drei Schaltkreise Demodulator, Entzerrer und Analog-Digital-Wandler jeweils voneinander getrennte und unabhängige Funktionen haben.

Es ist daher die Aufgabe der Erfindung, einen Demodulator zur Umsetzung eines FM-Eingangssignals in ein digitales Ausgangssignal anzugeben, der statt mit Analog-Technik-Bauteilen weitgehend mit integrierten Schaltkreisen realisierbar ist. Die Aufgabe wird wie im Patentanspruch 1 angegeben gelöst. Weiterbildungen sind den Unteransprüchen entnehmbar.

Die Erfindung wird nun anhand der Zeichnung beispielsweise näher erläutert. Es zeigt:

Fig. 1      ein Blockschaltbild des erfindungsgemäßen Demodulators,

Fig. 2      einen Phasengang des Allpaßfilters 6 aus Fig. 1 und

Fig. 3      Kurven zur Erläuterung der Umsetzung des FM-
bis 5       Eingangssignals in ein pulsdauermoduliertes Signal im Impulsgenerator 5 aus Fig. 2 bei verschiedenen Frequenzen des Eingangssignals.

H.Chang 2-6-8

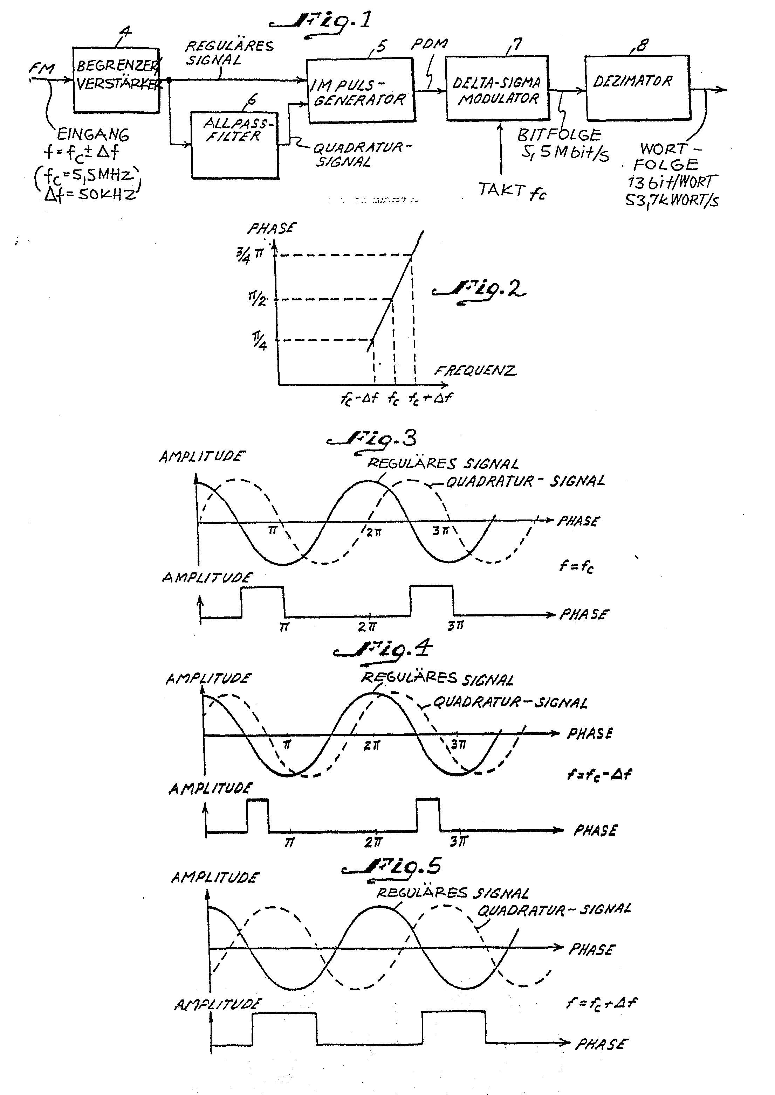

Im Blockschaltbild nach Fig. 1 wird das analoge FM-Eingangssignal vom Ausgang eines nicht gezeigten Zwischenfrequenzverstärkers, beispielsweise in einem Fernsehempfangsgerät, einem Begrenzer-Verstärker 4 zugeführt, der unerwünschte Amplitudenschwankungen des FM-Signals beseitigt. Beispielsweise hat das FM-Eingangssignal eine Mittenfrequenz von $f_c$ = 5,5 MHz mit einem Frequenzhub von $\pm\Delta f$ = 50 kHz.

Das Ausgangssignal des Begrenzers-Verstärkers 4 gelangt einerseits direkt auf den einen Eingang eines Impulsgenerators 5 und andererseits über ein Allpaßfilter 6 zum anderen Eingang des Impulsgenerators 5. Der Impulsgenerator 5 verarbeitet also zwei Eingangssignale, das reguläre Signal (FM-Signal) und ein Quadratursignal (verzögerte Version des FM-Signals), das vom Allpaßfilter 6 geliefert wird. Der Impulsgenerator 5 erzeugt einen Ausgangsimpuls, wenn das reguläre Eingangssignal negativ und das Quadratursignal positiv ist. Das Allpaßfilter 6, das ein LC-Filter ist, kann als eine Verzögerungsschaltung mit frequenzabhängiger Verzögerung betrachtet werden. Wenn das FM-Signal nicht von der Mittenfrequenz $f_c$ abweicht, so hat das Quadratursignal eine Phasenverzögerung von $90^o$ gegenüber dem ursprünglichen FM-Signal, d. h. dem regulären Signal. Bei einer Frequenzabweichung jedoch variiert die Phasenverzögerung des Quadratursignals proportional zur vorliegenden Frequenzabweichung.

Der Phasengang des Allpaßfilters 6 ist in Fig. 2 gezeigt, und die Umsetzung des FM-Signals in ein pulsdauermoduliertes Signal (PDM-Signal) ist in den Figuren 4 bis 6 dargestellt

H.Chang 2-6-8

für den Fall, daß $f = f_c$, $f = f_c - \Delta f$ und $f = f_c + \Delta f$ ist. Aus den Figuren 4 bis 6 ist ersichtlich, daß die Breite der Impulse des pulsdauermodulierten Signals durch die Zeitpunkte bestimmt wird, zu denen das reguläre Signal die Horizontalachse mit der Amplitude Null in negativer Richtung durchläuft und durch die Zeitpunkte, zu denen das Quadratursignal diese Achse ebenfalls in negativer Richtung durchläuft. Somit könnte der Impulsgenerator 5 als logische Schaltung realisiert werden, die beim Durchgang des regulären Signals in negativer Richtung den Ausgang einschaltet, d. h. ein positives Ausgangssignal abgibt und beim Durchgang des Quadratursignals in ebenfalls negativer Richtung durch die Achse den Ausgang unwirksam schaltet, d. h. den Impuls beendet. Durch diesen Ein- und Ausschaltvorgang wird ein Impuls des pulsdauermodulierten Signals erzeugt. Zur Realisierung des Impulsgenerators 5 wäre auch eine Schaltung möglich, welche die Dauer die Impulse gleich den Zeiten macht, während derer das reguläre Signal negativ und gleichzeitig das Quadratursignal positiv ist, so daß das in den Figuren 6 gezeigte pulsdauermodulierte Ausgangssignal erzeugt wird. Aufgrund der Arbeitsweise des Impulsgenerators, die bestimmt ist durch die Zeitpunkte der Nulldurchgänge und die augenblickliche Frequenz des Eingangssignals, ist das Ausgangssignal unempfindlich gegenüber Amplitudenschwankungen des Eingangssignals.

Wenn ein analoges Ausgangssignal erwünscht wäre, so könnte das Ausgangssignal des Impulsgenerators 5 in einem Tiefpaß gefiltert werden, der dann das analoge Ausgangssignal liefert.

H.Chang 2-6-8

Da aber ein digitales Ausgangssignal erwünscht ist, wird das Ausgangssignal des Impulsgenerators 5 einer Analog-Digital-Wandlung unterzogen. Wie in Fig. 1 gezeigt, geschieht dies in einem Delta-Sigma-Modulator, der mit einem Takt versorgt wird, dessen Taktfrequenz gleich der Mittenfrequenz $f_c$ des FM-Eingangssignals ist, und in einem nachgeschalteten Dezimator/Entzerrer 8.

Der Modulator 7, der mit dem Takt der Frequenz $f_c$ betrieben wird, setzt das pulsdauermodulierte Signal in eine Bitfolge um, wobei bei jedem Taktimpuls des Modulatortakts genau ein Bit erzeugt wird. Jedes dieser Bits gibt die Änderungsrichtung der Amplitude an. Diese Bitfolge, die auch als digitales Zwischensignal bezeichnet werden kann, wird dem Dezimator/Begrenzer 8 zugeführt, der davon ein Digitalsignal mit 13 Bits pro Wort und einer Bitfolgefrequenz ableitet, die gegenüber der Bitfolgefrequenz seines Eingangssignals herabgesetzt ist. Beim vorliegenden Beispiel hat das digitale Ausgangssignal des Dezimators/Entzerrers 8 eine Wortfolgefrequenz von 53,7 kwort/s. Dies ist das digitale Ausgangssignal des erfindungsgemäßen Demodulators.

Der Dezimator-Teil des Dezimators/Entzerrers 8 ist ein Tiefpaß, dessen Schaltung und Arbeitsweise in der US-PS 4 302 631 beschrieben ist. Durch Einstellung der Charakteristik des Dezimators kann die am FM-Signal vor der Übertragung zur Vergrößerung des Geräuschabstands vorgenommene Preemphase-Verzerrung beseitigt werden, so daß das digitale Ausgangssignal des Demodulators schließlich frei von Verzerrungen ist.

H.Chang 2-6-8

Der erfindungsgemäße FM-Demodulator läßt sich vollständig als integrierter Schaltkreis bei geringeren Kosten und bei einfacherer Herstellung als ein FM-Demodulator bekannter Art realisieren. Es sei darauf hingewiesen, daß die Vereinfachung der Bauweise des erfindungsgemäßen FM-Demodulators unter anderem dadurch bewirkt wird, das die Entzerrung des FM-Signals in einer Stufe durchgeführt wird, die außerdem noch eine andere Funktion hat.

0089624


INTERNATIONAL STANDARD ELECTRIC
CORPORATION, NEW YORK


H.Chang-K.Shenoi-B.P.Agrawal 2-6-8

Patentansprüche

1. Demodulator zur Umsetzung eines frequenzmodulierten
Eingangssignals in ein digitales Ausgangssignal, d a -
d u r c h   g e k e n n z e i c h n e t, daß er aus
einem ersten Teil (4, 6, 5) besteht, der das frequenzmodulierte Eingangssignal in ein pulsdauermoduliertes Signal
umsetzt, und aus einem zweiten Teil (7, 8) der das pulsdauermodulierte Signal in ein digitales Ausgangssignal
umsetzt, das dem frequenzmodulierten Eingangssignal entspricht.


2. Demodulator nach Anspruch 1, dadurch gekennzeichnet,
daß der erste Teil eine Verzögerungsschaltung (6) mit
frequenzabhängiger Verzögerung enthält, die vom frequenzmodulierten Eingangssignal ein verzögertes Signal ableitet,
und einen Impulsgenerator (5) der aufgrund des frequenzmodulierten Eingangssignals und des verzögerten Signals
das pulsdauermodulierte Signal erzeugt.


3. Demodulator nach Anspruch 2, dadurch gekennzeichnet,
daß die Verzögerungsschaltung (6) ein Allpaßfilter ist.


4. Demodulator nach Anspruch 2 oder 3, dadurch gekennzeichnet, daß der erste Teil am Eingang einen Begrenzer-


ZT/P1-Kg/R
07.03.1983                                          -2-

H.Chang 2-6-8

Verstärker (4) enthält, dessen Ausgang mit dem Eingang des Impulsgenerators (5) und mit dem Eingang der Verzögerungsschaltung (6) verbunden ist.

5. Demodulator nach einem der Ansprüche 1 bis 4, dadurch gekennzeichnet, daß im Impulsgenerator (5) die Zeiten, während derer das frequenzmodulierte Eingangssignal negativ und gleichzeitig das verzögerte Signal positiv ist, die Dauer der Impulse des erzeugten pulsdauermodulierten Signals bestimmen.

6. Demodulator nach einem der Ansprüche 1 bis 4, dadurch gekennzeichnet, daß im Impulsgenerator (5) die Zeitpunkte, zu denen das frequenzmodulierte Eingangssignal in negativer Richtung eine Bezugsspannung durchläuft, die Vorderflanken und die Zeitpunkte, zu denen das verzögerte Signal ebenfalls in negativer Richtung dieselbe Bezugsspannung durchläuft, die Hinterflanken der Impulse des erzeugten pulsdauermodulierten Signals bestimmen.

7. Demodulator nach einem der vorstehenden Ansprüche, dadurch gekennzeichnet, daß der zweite Teil (7, 8) einen dem ersten Teil nachgeschalteten Analog-Digital-Wandler (7) aufweist, der ein digitales Zwischensignal mit vorbestimmter Bitfolgefrequenz erzeugt, und einen diesem nachgeschalteten Dezimator (8), der von diesem digitalen Zwischensignal das digitale Ausgangssignal mit einer gegenüber der vorbestimmten Bitfolgefrequenz herabgesetzten Bitfolgefrequenz ableitet.

8. Demodulator nach Anspruch 7, dadurch gekennzeichnet, daß der Analog-Digital-Wandler (7) ein Delta-Sigma-Modulator ist, dessen Takt eine der vorbestimmten Bitfolgefrequenz gleiche Taktfrequenz hat.

H.Chang 2-6-8

9. Demodulator nach Anspruch 7 oder 8, dadurch gekennzeichnet, daß die vorbestimmte Bitfolgefrequenz gleich
der Mittenfrequenz ($f_c$) des frequenzmodulierten Eingangssignals ist.

10. Demodulator nach einem der Ansprüche 7 bis 9, dadurch
gekennzeichnet, daß der Dezimator (8) im Falle eines
frequenzmodulierten Eingangssignals, das vor der Übertragung ein Preemphase-Netzwerk durchlaufen hat, die
vorhandene Preemphase-Verzerrung beseitigt.

0089624

## Fig.1

FM → BEGRENZER VERSTÄRKER (4) → REGULÄRES SIGNAL → IMPULS-GENERATOR (5) → PDM → DELTA-SIGMA MODULATOR (7) → DEZIMATOR (8)

ALLPASS-FILTER (6) → QUADRATUR-SIGNAL

EINGANG
$f = f_c \pm \Delta f$
$\begin{pmatrix} f_c = 5,5\,MHZ \\ \Delta f = 50\,KHZ \end{pmatrix}$

TAKT $f_c$

BITFOLGE 5,5 Mbit/s

WORT-FOLGE
13 bit/WORT
53,7 kWORT/s

## Fig.2

PHASE
3/4 π
π/2
π/4
FREQUENZ
$f_c - \Delta f$  $f_c$  $f_c + \Delta f$

## Fig.3

AMPLITUDE — REGULÄRES SIGNAL — QUADRATUR-SIGNAL
PHASE
π  2π  3π
$f = f_c$
AMPLITUDE
PHASE
π  2π  3π

## Fig.4

AMPLITUDE — REGULÄRES SIGNAL — QUADRATUR-SIGNAL
PHASE
π  2π  3π
$f = f_c - \Delta f$
AMPLITUDE
PHASE
π  2π  3π

## Fig.5

AMPLITUDE — REGULÄRES SIGNAL — QUADRATUR-SIGNAL
PHASE
$f = f_c + \Delta f$
AMPLITUDE
PHASE